# EUROPÄISCHE PATENTSCHRIFT

(11) **EP 0 352 593 B1**
(45) Veröffentlichungstag und Bekanntmachung des Hinweises auf die Patenterteilung: **21.09.1994**
(21) Anmeldenummer: 89113090.8
(22) Anmeldetag: 17.07.1989
(51) Int. Cl.: H02H 7/093, G08B 21/00

(54) **Überwachungseinrichtung für einen Lüfter**
Monitoring device for a ventilator
Dispositif de surveillance pour un ventilateur

(30) Priorität: 28.07.1988 DE 3825707
(43) Veröffentlichungstag der Anmeldung: 31.01.1990
(73) Patentinhaber: SIEMENS AKTIENGESELLSCHAFT, 80333 München (DE)
(72) Erfinder: Bliesner, Jürgen, D-8551 Hemhofen (DE)

(56) Entgegenhaltungen:
- CH-A- 354 500
- US-A- 4 513 233
- US-A- 4 544 852

## Beschreibung

Die Erfindung bezieht sich auf eine Überwachungseinrichtung für einen Lüfter ,der mittels eines elektronisch kommutierenden Motors angetrieben wird, dem bei ordnungsgerechtem Betrieb eine pulsierende Gleichspannung einer vorgegebenen Polarität entnehmbar ist, die einem Hochpaß zuleitbar ist, durch den eine Wechselspannung generierbar ist.

Lüfter werden zur Temperierung bzw. Kühlung elektronischer Baugruppen oder anderer, hochempfindlicher Baueinheiten eingesetzt, die im Betrieb Wärme entwickeln und temperaturempfindlich sind. Deshalb müssen die Baugruppen oder Bauelemente auf ihre jeweilige Betriebstemperatur gehalten werden, die konstant ist oder nur innerhalb eines kleinen Temperaturbereichs schwanken dürfen. Die beim Betrieb solcher Baugruppen anfallende Wärme wird durch den Luftstrom des Lüfters abgeführt. Bei Nachlassen oder Ausfall der Kühlung durch den Lüfter treten an den elektronischen Baugruppen Betriebsstörungen auf, die bis zu deren Zerstörung führen können. Um solche Folgeschäden und ihre wirtschaftlichen Auswirkungen zu vermeiden, ist daher eine Überwachung des Lüfterbetriebes vorzusehen.

Bei der aus der DE-OS 22 58 252 bekannten Überwachungseinrichtung stellen ein stromführender Widerstand, der von einem Lüfter gekühlt wird, und ein Bimetallschalter, der in einem bestimmten Abstand zu dem Widerstand angebracht ist, den Sensor zur Überwachung des Lüfters dar. Bei Ausfall der Lüfterkühlung erwärmt sich der Widerstand und er erhitzt infolge hoher Strahlungswärme den Bimetallschalter. Dadurch unterbricht der Bimetallschalter die Stromversorgung eines Relais, das daraufhin den Stromkreis der zu kühlenden Baugruppen oder Bauelementen unterbricht. Bei einer solchen Überwachungseinrichtung kann sich durch Verschmutzung des Widerstandes und des Bimetallschalters deren Empfindlichkeit verändern, wodurch die Unterbrechung des Stromkreises der zu kühlenden Baugruppen bzw. Bauelementen bei Ausfall des Lüfters zu spät erfolgt. Weiterhin kann der Aufbau einer solchen Vorrichtung in manchen Anwendungensfällen nicht robust genug ausgeführt werden.

Aus der US-A-4 544 852 ist eine Überwachungseinrichtung der eingangs genannten Art bekannt, die jedoch insbesondere durch die Verwendung empfindlicher Komparatoren einen nicht unerheblichen Schaltungsaufwand bedingt.

Der Erfindung liegt nun die Aufgabe zugrunde, eine Überwachungseinrichtung anzugeben, die eine hohe Betriebssicherheit und eine äußerst einfache elektronische Schaltung aufweist.

Diese Aufgabe wird bei einer Überwachungseinrichtung der eingangs genannten Art dadurch gelöst, daß aus der Wechselspannung durch eine Gleichrichterschaltung eine Gleichspannung gewonnen werden kann, wobei die Gleichrichterschaltung an einen elektronischen Verstärker geschaltet ist, dessen Ausgangssignal entweder den ordnungsgerechten oder den fehlerhaften Betrieb des Motors detektiert, und daß die Wechselspannung eine solche Gleichrichtung erfährt, daß die resultierende Gleichspannung von entgegengesetzter Polarität zur pulsierenden Gleichspannung ist, wobei die resultierende Gleichspannung bei ordnungsgerechtem Betrieb des Motors sperrend auf die Eingangsstufe des elektronischen Verstärkers einwirkt.

Die Wechselspannung wird also so gleichgerichtet, daß das Ausgangssignal der Gleichrichtung eine gegenüber dem ursprünglichen Eingangssignal, d.h. der zugeführten pulsierenden Gleichspannung, eine invertierte Gleichspannung liefert. Damit ist es möglich, daß die folgende Gleichstromverstärkungsschaltung ohne einen aufwendigen Komparator auskommt, weil nämlich durch die invertierte Gleichspannung die Möglichkeit besteht, den Eingang durch das Ausgangssignal der Gleichrichterstufe bei ordnungsgemäßem Betrieb der Schaltung in einen Sperrzustand zu bringen.

Die an einer Klemme des Motors anstehende Spannung ist proportional der Ausgangsspannung eines Stromrichterventils des den Motor speisenden Stromrichters bzw. der Kollektorspannung eines Schalttransistors, wenn der Stromrichter mit Schalttransistoren aufgebaut und deren Frequenz proportional der Drehzahl des Motors ist. Das heißt, am Signaleingang der Überwachungseinrichtung steht eine rechteckförmige Spannung an, deren Pegel zwischen Null Volt und einem maximalen positiven Wert in Abhängigkeit der Drehzahl des Motors wechselt.

Die Überwachungseinrichtung wertet mit Hilfe des Filters, des Spitzenwertgleichrichters und der Gleichstromverstärkerschaltung die Frequenz des am Signaleingang anstehenden rechteckförmigen Spannung aus. Sobald die Drehzahl des Motors unterhalb eines der Drehzahl bzw. der Frequenz proportionalen Grenzspannungswertes absinkt, wechselt am Ausgang der Überwachungseinrichtung das Ausgangssignal seinen Wert vom High-Pegel zum Low-Pegel. Somit kann man am Ausgangssignal der Überwachungseinrichtung feststellen, ob der Lüfter noch dreht, wobei kein Sensor verwendet wird, der durch seine Anbringung im Lüfterstrom infolge des Betriebs des Lüfters verschmutzen kann, und somit die Betriebssicherheit verringern würde. Außerdem besteht die Schaltung der Überwachungseinrichtung aus standardisierten, einfachen Schaltungsteilen, so daß die Schaltung der Überwachungseinrichtung auch integriert ausgeführt werden kann.

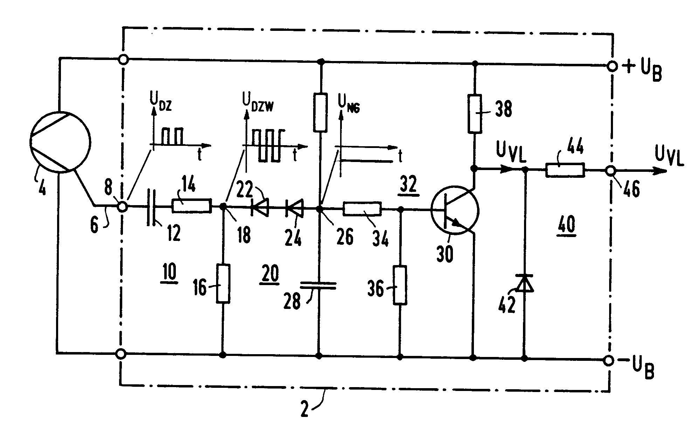

Zur weiteren Erläuterung der Erfindung einschließlich der durch die Unteransprüche angegebenen vorteilhaften Ausbildungen wird auf die Zeichnung Bezug genommen, in der ein Ausführungsbeispiel nach der Erfindung schematisch veranschaulicht ist.

Die Figur zeigt eine Schaltungsanordnung der Überwachungseinrichtung 2 und einen Lüfter 4, der an eine Versorgungsspannung +U_{B},-U_{B} angeschlossen ist. Dieser Lüfter 4 wird mittels eines elektronisch kommutierenden Motors angetrieben, der über einen elektronisch kommutierenden Motor angetrieben, der über einen Stromrichter aus dem Versorgungsnetz +U_{B},-U_{B} gespeist wird. Aus Übersichtlichkeitsgründen sind der Motor und der Stromrichter nicht dargestellt. Vom Stromrichter bzw. von einer Klemme des Motors gelangt ein der Drehzahl proportionales Signal U_{DZ} mittels einer Signalleitung 6 zum Signaleingang 8 der Überwachungseinrichtung 2. Diesem Signaleingang 8 ist ein Filter 10 nachgeschaltet. Als Filter 10 ist ein Hochpaß, bestehend aus einem Kondensator 12 und zwei in Reihe geschalteter Widerstände 14 und 16, vorgesehen. Dabei ist das Filter 10 so bemessen, daß am Ausgang 18 des Filters 10 nur der Wechselanteil des mit einem Gleichanteil behafteten rechteckförmigen Signal U_{DZ} ansteht. Aus diesem rechteckförmigen Wechselsignal U_{DZW} wird mittels eines Spitzenwertgleichrichters 20 ein negatives Gleichspannungssignal U_{NG} erzeugt. Dieser Spitzenwertgleichrichter 20 besteht aus zwei in Reihe geschalteter Dioden 22 und 24, wobei die Kathode der Diode 22 mit dem Ausgang 18 des Filters 10 und die Anode der Diode 24 einerseits mit einem Ausgang 26 des Spitzenwertgleichrichters 20 und andererseits mit einem Anschluß eines Kondensators 28 elektrisch leitend verbunden ist, dessen anderer Anschluß mit einer negativen Versorgungsspannung -U_{B} verknüpft ist. Die beiden Dioden 22 und 24 bestimmen die Amplitude des Ausgangssignals U_{NG} des Spitzenwertgleichrichters 20. Durch dieses negative Gleichspannungssignal U_{NG}, das an der Basis eines Transistors 30 einer nachgeschalteten Gleichstromverstärkerschaltung 32 ansteht, ist dieser sperrend geschaltet. Die Widerstände 34 und 36 bestimmen in bekannter Weise den Arbeitspunkt des Transistors 30, wobei ein Widerstand 38 den Kollektorstrom bestimmt. Dieser Gleichstromverstärkerschaltung 32 ist eine Schutzschaltung 40, bestehend aus einer in Sperrichtung gepolten Diode 42 und einem Widerstand 44, nachgeschaltet. Am Ausgang 46 dieser Schutzschaltung 40 ist ein Ausgangssignal U_{VL} abnehmbar, das entweder einen High-Pegel oder einen Low-Pegel aufweist. Der High-Pegel dieses Ausgangssignals U_{VL} kennzeichnet den Zustand, daß der Lüfter 4 bzw. der Motor des Lüfters 4 oberhalb einer Mindestdrehzahl, bestimmt durch die negative Amplitude des Gleichspannungssignals U_{NG}, liegt, der Low-Pegel zeigt an, daß der Lüfter 4 bzw. der Motor des Lüfters 4 unterhalb der genannten Drehzahlgrenze liegt bzw. stillsteht. Dieses Ausgangssignal U_{VL} kann einer Verarbeitungsschaltung, die aus Übersichtlichkeitsgründen nicht dargestellt ist, zugeführt werden, die dann den Stromkreis der zu kühlenden Baugruppen bzw. Bauelemten unterbricht.

Somit zeigt die Figur eine Schaltanordnung einer Überwachungseinrichtung 2 für einen Lüfter 4, mit der der Lüfter 4 auf Ausfall überwacht werden kann, wobei die Schaltungsanordnung einfach und kompakt aufgebaut ist, deren Empfindlichkeit sich während des Einsatzes nicht ändert, da kein Sensor verwendet wird, der infolge des Betriebs des Lüfters 4 verschmutzen kann. Als Überwachungsmittel wird beispielsweise eine vom Stromrichter des elektrisch kommutierenden Motors erzeugte Signal von der Überwachungsschaltung 2 ausgewertet.

## Patentansprüche

1. Überwachungseinrichtung (2) für einen Lüfter (4), der mittelt eines elektronisch kommutierenden Motors angetrieben wird, dem bei ordnungsgerechtem Betrieb eine pulsierende Gleichspannung (U_{DZ}) einer vorgegebenen Polarität entnehmbar ist, die einem Hochpaß (10) zuleitbar ist, durch den eine Wechselspannung (U_{DZW}) generierbar ist, dadurch gekennzeichnet, daß aus der Wechselspannung (U_{DZW}) durch eine Gleichrichterschaltung (20) eine Gleichspannung (U_{NG}) gewonnen werden kann, wobei die Gleichrichterschaltung (20) an einen elektronischen Verstärker (32) geschaltet ist, dessen Ausgangssignal (U_{VL}) entweder den ordnungsgerechten oder den fehlerhaften Betrieb des Motors detektiert, und daß die Wechselspannung (U_{DZW}) eine solche Gleichrichtung erfährt, daß die resultierende Gleichspannung (U_{NG}) von entgegengesetzter Polarität zur pulsierenden Gleichspannung (U_{DZ}) ist, wobei die resultierende Gleichspannung (U_{NG}) bei ordnungsgerechtem Betrieb des Motors sperrend auf die Eingangsstufe des elektronischen Verstärkers (32) einwirkt.

2. Überwachungseinrichtung nach Anspruch 1, **dadurch gekennzeichnet**, daß dem elektronischen Verstärker (32) eine Schutzschaltung (40) nachgeschaltet ist.

3. Überwachungseinrichtung nach Anspruch 1 oder 2, **dadurch gekennzeichnet**, daß als Gleichrichter ein Spitzenwertgleichrichter (20) vorgesehen ist.

4. Überwachungseinrichtung nach einem der vorstehenden Ansprüche, **dadurch gekennzeichnet**, daß der Gleichrichter (20) mehrere in Reihe geschaltete Dioden (22,24) enthält.

## Claims

1. Monitoring equipment (2) for a ventilator (4) driven by an electronically commutating motor from which, in normal operation, a pulsating DC voltage (U_{DZ}) of specific polarity can be taken and fed to a high-pass filter (10) from which an AC voltage (U_{DZW}) can be generated, characterised by the fact that a DC voltage (U_{NG}) can be obtained from the AC voltage (U_{DZW}) by means of a rectifier circuit (20) (the rectifier circuit (20) being connected to an electronic amplifier (32), the output signal from which (U_{VL}) detects that the motor is functioning either normally or defectively); and by the fact that the AC voltage (U_{DZW}) undergoes rectification such that the resulting DC voltage (U_{NG}) is of opposite polarity to the pulsating DC voltage (U_{DZ}), the resultant DC voltage (U_{NG}) having a blocking effect on the input stage of the electronic amplifier (32) when the motor is operating normally.

2. Monitoring equipment in accordance with Claim 1, characterised by the fact that a protective circuit (40) is connected in series to the electronic amplifier (32).

3. Monitoring equipment in accordance with Claim 1 or 2, characterised by the fact that the rectifier provided is a peak-value rectifier (20).

4. Monitoring equipment in accordance with one of the preceding claims, characterised by the fact that the rectifier (20) contains several diodes (22, 24) connected in series.

## Revendications

1. Dispositif (2) de contrôle pour un ventilateur (4), qui est entraîné au moyen d'un moteur à commutation électronique, dont peut être prélevée, en fonctionnement correct, une tension continue pulsatoire (U_{DZ}) de polarité prescrite et qui peut être envoyée à un filtre passe-haut (10), par lequel on peut produire une tension alternative (U_{DZW}), caractérisé en ce qu'à partir de la tension alternative (U_{DZW}) on peut obtenir, au moyen d'un circuit redresseur (20), une tension continue (U_{NG}), le circuit redresseur (20) étant connecté à un amplificateur électronique (32), dont le signal (U_{VL}) de sortie détecte fonctionnement correct, soit le fonctionnement défectueux du moteur, et que la tension alternative (U_{DZW}) subit un redressement tel que la tension continue résultante (U_{NG}) est d'une polarité opposée à celle de la tension continue pulsatoire (U_{DZ}), la tension continue résultante (U_{NG}) ayant, en fonctionnement correct du moteur, une action de blocage sur l'étage d'entrée de l'amplificateur électronique (32).

2. Dispositif de contrôle suivant la revendication 1, caractérisé en ce qu'un circuit (40) de protection est branché en aval de l'amplificateur électronique (32).

3. Dispositif de contrôle suivant la revendication 1 ou 2, caractérisé en ce qu'il est prévu comme redresseur un redresseur (20) de valeurs de crête.

4. Dispositif de contrôle suivant l'une des revendications précédentes, caractérisé en ce que le redresseur (20) comporte plusieurs diodes (22, 24) branchées en série.
